# EUROPEAN PATENT SPECIFICATION

(11) **EP 3 676 883 B1**
(45) Date of publication and mention of the grant of the patent: **25.11.2026**
(21) Application number: 18851301.4
(22) Date of filing: 31.08.2018
(51) Int. Cl.: C30B 11/00, C30B 29/32, H10N 30/095

(54) **POLAR NANOREGIONS ENGINEERED RELAXOR-PBTIO3 FERROELECTRIC SINGLE CRYSTALS**
FERROELEKTRISCHE RELAXOR-PBTIO3-EINKRISTALLE MIT MANIPULIERTEN POLAREN NANOREGIONEN
CRISTAUX MONOCRISTALLINS FERROÉLECTRIQUES FORMÉS D'UN COMPLEXE RELAXEUR-PBTIO3 MODIFIÉS PAR DES NANORÉGIONS POLAIRES

(30) Priority: 01.09.2017 US 201762553511 P
(43) Date of publication of application: 08.07.2020
(73) Proprietor: TRS Technologies, Inc., State College, Pennsylvania 16801 (US); The Penn State Research Foundation, University Park, PA 16802 (US)
(72) Inventor: LUO, Jun, State College, PA 16801 (US); HACKENBERGER, Wesley S., State College, PA 16801 (US); LI, Fei, State College, PA 16801 (US); ZHANG, Shujun, State College, PA 16801 (US); SHROUT, Thomas R., Pennsylvania Furnace, PA 16865 (US)
(74) Representative: Prinz & Partner mbB
(86) International application number: PCT/US2018/049194
(87) International publication number: WO 2019/046777

(56) References cited:
- EP-A2- 1 479 796
- US-A- 6 117 355
- US-A1- 2011 311 815
- US-B2- 7 972 527
- ZHONG N ET AL: "Effect of rare earth additives on the microstructure and dielectric properties of 0.67Pb(Mg"1"/"3Nb"2"/"3)O"3-0.33PbTiO"3 ceramics", MATERIALS SCIENCE AND ENGINEERING: B, ELSEVIER, AMSTERDAM, NL, vol. 116, no. 2, 25 January 2005 (2005-01-25), pages 140 - 145, XP025304998, ISSN: 0921-5107, [retrieved on 20050125], DOI: 10.1016/J.MSEB.2004.09.030
- ZHANG, SHUJUN ET AL.: "Relaxor- PT single crystals: observations and developments", IEEE TRANSACTIONS ON ULTRASONICS, FERROELECTRICS, AND FREQUENCY CONTROL, vol. 57, no. 10, 2010, pages 2138 - 2146, XP011319212
- TIAN, JIAN ET AL.: "Crystal growth and property characterization for PIN-PMN- PT ternary piezoelectric crystals", JOURNAL OF ADVANCED DIELECTRICS, vol. 4, no. 1, 2014, pages 1350027--1 - 1350027--5, XP055592246, ISSN: 2010-135X, DOI: 10.1142/S2010135X13500276
- GARG, AJAI ET AL.: "Effect of rare earth (Er, Gd, Eu, Nd and La) and bismuth additives on the mechanical and piezoelectric properties of lead zirconate titanate ceramics", MATERIALS SCIENCE AND ENGINEERING: B, vol. 86, no. 2, pages 134 - 143, XP004296412, DOI: doi:10.1016/S0921-5107(01)00655-9

## Description

### CROSS-REFERENCE TO RELATED APPLICATIONS

This application claims the benefit of, and priority to, U.S. Provisional Application No. 62/553,511, Polar Nanoregions Engineered Relaxor-PbTiO3 Ferroelectric Crystals, which was filed on September 1, 2017.

### FIELD

The present application is directed toward the field of piezoelectric crystals and methods for forming piezoelectric crystals, and more particularly to binary/ternary relaxor-PT based piezoelectric crystals and methods for forming binary/ternary relaxor-PT based piezoelectric crystals.

### BACKGROUND

For the past 60 years, perovskite Pb(ZrₓTi₁₋ₓ)O₃ ("PZT") ferroelectric ceramics have been the mainstay piezoelectric materials for commercial markets of electronic devices, such as piezoelectric sensors, actuators and medical ultrasonic transducers, owing to their high dielectric, piezoelectric, and electromechanical coupling factors. Specifically, the compositions in the vicinity of the morphotropic phase boundary ("MPB") in Pb(ZrₓTi₁₋ₓ)O₃ (x=0.52), coexisting with the rhombohedral and tetragonal ferroelectric phases, exhibit anomalously high dielectric and piezoelectric properties as a result of enhanced polarizability arising from the coupling between two equivalent energy states, i.e., the tetragonal and rhombohedral phases, allowing optimum domain reorientation during poling. Numerous PZT formulations exist that have been engineered for specific characteristics that ultimately enhance their use in many applications. Table 1 lists the properties of exemplary commercially available soft PZT ceramics.

**Table 1. Piezoelectric and dielectric properties of commercial PZT5 type ceramics.**

| Ceramics | d₃₃ (pC/N) | kₚ | εᵣ | tanδ (%) |
|---|---|---|---|---|
| PZT5 | | | | |
| TRS200HD¹ | 400 | 0.66 | 2000 | 1.8 |
| 3195STD² | 350 | 0.63 | 1800 | 1.8 |
| 3295HD² | 390 | 0.65 | 1900 | 1.8 |
| PIC255³ | 400 | 0.62 | 1750 | 2.0 |
| PIC155³ | 360 | 0.62 | 1450 | 2.0 |
| PKI502⁴ | 425 | 0.60 | 2000 | 1.5 |
| PZ23⁵ | 328 | 0.52 | 1500 | 1.3 |
| PZ27⁵ | 425 | 0.59 | 1800 | 1.7 |
| PZT5A1⁶ | 410 | 0.62 | 1875 | 2.0 |
| PZT5A3⁶ | 374 | 0.60 | 1700 | 2.0 |

| PZT5H | | | | |
|---|---|---|---|---|
| TRS610HD¹ | 690 | 0.70 | 3900 | 1.8 |
| CTS3203STD² | 550 | 0.69 | 3250 | 2.0 |
| CTS3203HD² | 650 | 0.70 | 3800 | 2.0 |
| PIC151³ | 500 | 0.62 | 2400 | 2.0 |
| PIC153³ | 600 | 0.62 | 4200 | 3.0 |
| PKI532⁴ | 490 | 0.63 | 2700 | 2.0 |
| PKI552⁴ | 600 | 0.67 | 3400 | 2.2 |
| PZ21⁵ | 640 | 0.60 | 3980 | 1.6 |
| PZ29⁵ | 570 | 0.64 | 2870 | 1.6 |
| PZT5H1⁶ | 620 | 0.60 | 3400 | 1.8 |
| PZT5H2⁶ | 590 | 0.65 | 3400 | 2.5 |

| | | | | |
|---|---|---|---|---|
| ¹TRS Technologies Inc. ²CTS Corporation ³PI Ceramic GmbH ⁴Piezo-kinetics Inc. ⁵Ferroperm ⁶Morgan Advanced Materials plc | | | | |

In the late 1950s, unusual dielectric behavior was reported in complex perovskites with the chemical formula of Pb(M_{I},M_{II})O₃, where M_{I} is a low valence cation and M_{II} is a high valence cation, generally referred to as a relaxor. Materials with this chemical structure exhibit frequency-dispersive dielectric permittivity, being related with the existence of polar nanoregions ("PNRs"). Of the many interesting relaxor materials discovered, lead magnesium niobate ("PMN") exhibited high dielectric permittivities and a strong nonhysteretic electrostrictive effect at room temperature. In the late 1970s, it was discovered that by creating a solid solution of PMN with the addition of the normal ferroelectric perovskite PbTiO₃ ("PT"), the Curie point and the nonhysteretic quadratic strain increased. This finding was quickly followed by the discovery that with increased compositional levels of PT, the electrostrictive behavior of PMN-PT was replaced by a more "classical" ferroelectric behavior, leading to the mapping of the PMN-PT binary phase diagram, which showed an MPB separating rhombohedral and tetragonal phases. Analogous to PZT, the piezoelectric properties of PMN-PT ceramics reach peak values at the MPB, being on the order of 700 pC/N. Of particular importance is that some of the relaxor-PT materials may be easily grown into single crystals, greatly enhance the piezoelectric and dielectric properties through the strong anisotropic characteristics and engineered domain configuration.

The excellent piezoelectric properties of Relaxor-PT single crystals, such as Pb(Mg_{1/3}Nb_{2/3})O₃-PbTiO₃ ("PMN-PT") and Pb(In_{1/2}Nb_{1/2})O₃-Pb(Mg_{1/3}Nb_{2/3})O₃-PbTiO₃ ("PIN-PMN-PT"), have attracted considerable research interest in the last two decades. Specifically, single crystal compositions near the morphotropic phase boundary ("MPB") with [001] poled engineered domain configuration exhibit longitudinal piezoelectric coefficients (d₃₃) greater than 1500 pC/N with electromechanical coupling factors higher than 0.90 (see S. Zhang and F. Li, High Performance Ferroelectric Relaxor-PT Single Crystals: Status and Perspective, J. Appl. Phys. III (2012) 031301). For example, the typical crystal properties of two compositions are listed at the top in Table 2. All these excellent properties make relaxor-PT single crystals promising candidates for broadband and high sensitivity ultrasonic transducers, sensors and other electromechanical devices (see S. Zhang, F. Li, X. Jiang, J.Kim, J. Luo, X. Geng, Advantages and Challenges of Relaxor-PT Ferroelectric Crystals for Electroacoustic Transducers - A Review, Prog. Mater. Sci., 68 (2015) 1-66; S. Zhang, F. Li, J. Luo, R. Sahul, T. Shrout, Relaxor-PT Single Crystals for Various Applications, IEEE Trans. Ultrason., Ferro., Freq. Control, 60(2013) 1572).

Innovations in piezoelectric devices have been the driving force for new developments in ferroelectric materials. In order to meet newly developed electromechanical devices, materials with higher dielectric and piezoelectric properties, when compared to legacy PZT and PMNT based materials, are desired. For example, piezoelectric sensors and actuators require higher piezoelectric coefficients d₃₃ > 3,000 pC/N, while medical imaging transducers are demanding high electromechanical coupling factors k₃₃ (≥0.9), since bandwidth and sensitivity of transducers are closely associated with the square of coupling factor. Of particular importance is that array transducers require high dielectric permittivity, meanwhile maintain the very high electromechanical couplings, due to the fact that the dielectric permittivity is inversely related to the electrical resistivity. In order to decrease the power dissipation and reduce the noise/crosstalk, transducer devices need high dielectric permittivity of the piezoelectric materials for electrical impedance matching, which is generally 50 Ω as standard. Even the relaxor-PT crystals were reported to possess very high free dielectric permittivity >5,000, but the clamped dielectric permittivity is below 1,000, due to the high electromechanical coupling factor (see S. Zhang, F. Li, X. Jiang, J.Kim, J. Luo, X. Geng, Advantages and Challenges of Relaxor-PT Ferroelectric Crystals for Electroacoustic Transducers- A Review, Prog. Mater. Sci., 68 (2015) 1-66). Previous efforts have focused on the morphotropic phase boundary design, establishing rhombohedral to tetragonal compositional phase, and/or rhombohedral to orthorhombic / monoclinic to tetragonal phase boundaries, to enhance the piezoelectric and clamped dielectric properties, but only with limited success.

Recently, the contribution of polar nanoregions ("PNRs") in relaxorbased ferroelectrics has been theoretically modeled to be the origin of the ultrahigh dielectric and piezoelectric activities of relaxor based perovskite ferroelectrics, accounting for 50-80% of their respective room temperature values (F. Li et al., The Origin of Ultrahigh Piezoelectricity in Relaxor-Ferroelectric Solid Solution Crystals, Nature Communications, 7, 13807 (2016)). Analogous to PZT, relaxor-PT solid solutions were reported to possess good dielectric and piezoelectric properties, comparable to PZT, with MPB compositions, while the PNRs in the relaxor component also contribute to the high dielectric permittivity, which may be explained by the "collinear" state of the PNRs with the ferroelectric matrix. Thus, it would be desirable to control the size and volume of PNR, i.e., to control the local structure impact on the nearby lattice, to design new material systems with enhanced dielectric properties.

EP 1 479 796 A1 discloses a piezoelectric single crystal device for actively employing the electromechanical coupling factor k 31 in the direction orthogonal to the polarization direction is provided. Specifically, with the polarization direction as [001] axis of a pseudocubic system, an angle between the normal direction 1 of the piezoelectric device edge face and the direction n orthogonal to the domain structure within the crystal face including [010] and [100] axes orthogonal to the polarization direction is in the range 0 to 15° or 40 to 50°.

From US 7 972 527 B2 a ternary single crystal relaxor piezoelectric is known, which is grown from a novel melt using the Vertical Bridgeman method. The ternary single crystals are characterized by a Curie temperature, Tc, of at least 150° C. and a rhombohedral to tetragonal phase transition temperature, Trt, of at least about 110° C. The ternary crystals further exhibit a piezoelectric coefficient, d33, in the range of at least about 1200-2000 pC/N.

Zhong et al. describe in a scientific article microstructure and dielectric properties of relaxor ferroelectrics in the solid solution, formulated 0.67Pb(Mg_{1/3}Nb_{2/3})O₃-0.33PbTiO₃ + 2 mol% RE (RE = Sm, Nd, Yb or Ce. In this article, Zhong et al. exclusively disclose polycrystalline ceramic materials. No properties or synthesis routes for single crystals are provided.

### SUMMARY

The invention is directed to relaxor-PT based piezoelectric crystals according to claim 1 and a method for forming the same according to claim 12.

According to claim 1, a relaxor-PT based piezoelectric crystal comprises the general formula of (Pb_{1-1.5x}Mₓ){[(M_{I},M_{II})_{1-z}(M_{I'},M_{II'})_{z}]_{1-y}Ti_{y}}O₃, wherein: M is a rare earth cation; M_{I} is selected from the group consisting of Mg²⁺, Zn²⁺, Yb³⁺, Sc³⁺, and In³⁺; M_{II} is Nb⁵⁺; M_{I'} is selected from the group consisting of Mg²⁺, Zn²⁺, Yb³⁺, Sc³⁺, In³⁺ and Zr⁴⁺; M_{II'} is Nb⁵⁺ or Zr⁴⁺; 0 < x ≤ 0.05; 0.02 < y < 0.7; and 0 ≤ z ≤ 1, provided that if either M_{I'} or M_{II'} is Zr⁴⁺, both M_{I'} and M_{II'} are Zr⁴⁺, provided that M is selected from the group consisting of Nd³⁺, Pm³⁺, Sm³⁺, Gd³⁺ and combinations thereof, and wherein the relaxor-PT based piezoelectric crystal is a single crystal boule.

According to claim 12, a method for forming a relaxor-PT based piezoelectric crystal comprises pre-synthesizing precursor materials by calcining mixed oxides at a first calcination temperature, mixing the precursor materials with single oxides and calcining at a second calcination temperature lower than the first calcination temperature to form a feeding material having the general formula of (Pb_{1-1.5x}Mₓ){[(M_{I},M_{II})_{1-z}(M_{I'},M_{II'})_{z}]_{1-y}Ti_{y}}O₃, and growing the relaxor-PT based piezoelectric crystal having the general formula of (Pb_{1-1.5x}Mₓ){[(M_{I},M_{II})_{1-z}(M_{I'},M_{II'})_{z}]_{1- y}Ti_{y}}O₃ from the feeding material by a Bridgman method, wherein: M is a rare earth cation; M_{I} is selected from the group consisting of Mg²⁺, Zn²⁺, Yb³⁺, Sc³⁺, and In³⁺; M_{II} is Nb⁵⁺; M_{I'} is selected from the group consisting of Mg²⁺, Zn²⁺, Yb³⁺, Sc³⁺, In³⁺ and Zr⁴⁺; M_{II'} is Nb⁵⁺ or Zr⁴⁺; 0 < x ≤ 0.05; 0.02 < y < 0.7; and 0 ≤ z ≤ 1, provided that if either M_{I'} or M_{II'} is Zr⁴⁺, both M_{I'} and M_{II'} are Zr⁴⁺, provided that M is selected from the group consisting of Nd³⁺, Pm³⁺, Sm³⁺, Gd³⁺ and combinations thereof, and wherein the relaxor-PT based piezoelectric crystal is a single crystal.

### BRIEF DESCRIPTION OF THE DRAWINGS

FIG. 1 shows Sm-modified PMN-PT and PIN-PMN-PT single crystals grown by the vertical Bridgman process, according to an embodiment of the present disclosure.
FIG. 2 shows variations of dielectric permittivity along the length of the unmodified and Sm-modified PMN-PT (a) and PIN-PMN-PT (b) crystals (only the rhombohedral phase section and poled along <001>), according to an embodiment of the present disclosure.
FIG. 3 shows variations of piezoelectric coefficient along the length of the unmodified and Sm-modified PMN-PT (a) and PIN-PMN-PT (b) crystals (only the rhombohedral phase section and poled along <001>), according to an embodiment of the present disclosure.
FIG. 4 shows the as-grow single crystal from a mixture of PMN-32PT and 2 mol% Sm203, according to an embodiment of the present disclosure.
FIG. 5 shows the as-grow single crystal from a mixture of 26PIN-42PMN-32PT and 2 mol% Sm₂O₃, according to an embodiment of the present disclosure.
FIG. 6 shows (a) polarization and strain hysteresis loops under bipolar electric field, showing coercive field (E_{c}) and saturated polarization (Pₛ) (sample 1), and (b) dielectric permittivity variation with elevated temperature, showing the Curie temperature (T_{C}) (sample 2) in samples cut from the crystal growth from 2 mol% Sm: PMN-32PT mixture, according to an embodiment of the present disclosure.
FIG. 7 shows the (a) polarization loops under bipolar electrical field and (b) dielectric permittivity and loss variation with elevated temperature in samples cut from the crystal growth from 1 mol% Sm: 26PIN-PMN-30PT mixture, according to an embodiment of the present disclosure.
FIG. 8 shows the measured strain under unipolar electrical field of sample 1 (a) and sample 2 (b), according to an embodiment of the present disclosure.

Whenever possible, the same reference numbers will be used throughout the drawings to represent the same parts.

### DETAILED DESCRIPTION OF EXEMPLARY EMBODIMENTS

Provided are piezoelectric crystals and methods for forming piezoelectric crystals. Embodiments of the present disclosure, in comparison to methods not including one or more of the features disclosed herein, include decreased variations of dielectric permittivity and piezoelectric coefficient along a rhombohedral phase section, increased piezoelectric coefficients, increased free dielectric permittivities, increased clamped dielectric permittivities, maintaining electromechanical coupling, or combinations thereof.

The present invention relates to piezoelectric crystals suitable for high performance electromechanical applications, such as actuators, piezoelectric sensors, and medical ultrasonic transducers. As ferroelectric crystals capable of attaining a large piezoelectric coefficient and dielectric permittivity, meanwhile maintaining the high electromechanical coupling being on the order of about 0.9, there have hitherto been known, for example, a binary or ternary system composed of lead titanate (PbTiO₃; PT) and relaxor end members, such as Pb(M_{I},M_{II})O₃, where M_{I} may be Mg²⁺, Zn²⁺, Yb³⁺, Sc³⁺, orIn³⁺; while M_{II} may be Nb⁵⁺. Relaxor-PT single crystals have attracted extensive attentions in the last two decades for applications in high performance medical imaging transducers. However, because of the low clamped dielectric permittivity, such crystals have required more complicated designs for the electrical impedance matching.

The present disclosure relates to ferroelectric crystals based on relaxor-PT composition, characterized by high dielectric (both free and clamped dielectric permittivities) and electromechanical properties that may be adopted for different uses by modifying the PNRs volume ratio. The piezoelectric crystals based on the system Pb[(M_{I},M_{II})_{1-z}(M_{I'},M_{II'})_{z}]O₃-PT are modified in order to obtain a high level of dielectric/piezoelectric activity. The invention provides domain engineered piezoelectric crystals based on relaxor-PTs having the perovskite ABO₃ crystal structure, being furthermore substituted with heterovalent cations.

In this disclosure, the PNRs in relaxor-PT ferroelectric crystal systems were controlled by A-site modifications, demonstrating the impact of PNRs and/or local structure on the significantly improved dielectric and piezoelectric properties. A-site modified Pb[(M_{I},M_{II})_{1-z}(M_{I'},M_{II'})_{z}]O₃-PT binary/temary crystals have been found to possess high dielectric and piezoelectric properties compared to those of unmodified counterparts, attributing to the local structure distortion and/or existence of controlled PNRs, and/or local structure with different phases from nearby matrix, where the free/clamped dielectric permittivity and piezoelectric coefficients are greatly increased, while maintaining the high electromechanical coupling factors.

Since Pb[(M_{I},M_{II})_{1-z}(M_{I'},M_{II'})_{z}]O₃-PT binary/temary single crystals are complete solid solution systems as shown by high temperature phase diagrams, such crystals exhibit an inhomogeneous composition distribution along crystal boules grown by Bridgman method (Luo H, Xu G, Wang P, Yin Z, Growth and Characterization of Relaxor Ferroelectric PMNT Single Crystals, Ferroelectrics, 1999 231 685-690), resulting in the variation of dielectric and piezoelectric properties along the growth direction. However, as is presently disclosed, by A-site substitution with certain types of rare earth cations, the property variation along the crystal growth direction may be significantly reduced.

In one embodiment, a relaxor-PT based piezoelectric crystal comprises the general formula of (Pb_{1-1.5x}Mₓ){[(M_{I},M_{II})_{1-z}(M_{I'},M_{II'})_{z}]_{1-y}Ti_{y}}O₃, wherein: M is a rare earth cation; M_{I} is selected from the group consisting of Mg²⁺, Zn²⁺, Yb³⁺, Sc³⁺, and In³⁺, or any other suitable cation ; M_{II} is Nb⁵⁺, or any other suitable cation; M_{I'} is selected from the group consisting of Mg²⁺, Zn²⁺, Yb³⁺, Sc³⁺, In³⁺, Zr⁴⁺, or any other suitable cation; M_{II'} is Nb⁵⁺ or Zr⁴⁺, or any other suitable cation; 0 < x ≤ 0.05; 0.02 < y < 0.7; and 0 ≤ z ≤ 1, provided that if either M_{I'} or M_{II'} is Zr⁴⁺, both M_{I'} and M_{II'} are Zr⁴⁺.

In one embodiment, wherein z is 0, the crystal is a binary crystal. The binary crystal may include M_{I} being Mg²⁺, Zn²⁺, Yb³⁺, Sc³⁺, and In³⁺, or any other suitable cation, and M_{II} being Nb⁵⁺, or any other suitable cation.

In another embodiment, wherein z is greater than 0, the crystal is a ternary crystal. The ternary crystal may include M_{I} being Mg²⁺, Zn²⁺, Yb³⁺, Sc³⁺, and In³⁺, or any other suitable cation, and M_{II} being Nb⁵⁺, or any other suitable cation, and M_{I'} and M_{II'} each being Zr⁴⁺, or any other suitable cation. Alternatively, the ternary crystal may include M_{I} and M_{I'} each being independently Mg²⁺, Zn²⁺, Yb³⁺, Sc³⁺, and In³⁺, or any other suitable cation and M_{II} and M_{II'} each being Nb⁵⁺, or any other suitable cation.

M may be any suitable rare earth cation, including, but not limited to, La³⁺, Ce³⁺, Pr³⁺, Nd³⁺, Pm³⁺, Sm³⁺, Eu³⁺, Gd³⁺, Tb³⁺, Dy³⁺, Ho³⁺, Er³⁺, Tm³⁺, Yb³⁺, Lu³⁺, or combinations thereof. In one embodiment, M is Sm³⁺.

In one embodiment, the crystal is an M-modified Pb(Mg_{1/3}Nb_{2/3})O₃-PbTiO₃ ("PMNT"). In another embodiment, the crystal is an M-modified Pb(In_{1/2}Nb_{1/2})O₃- Pb(Mg_{1/3}Nb_{2/3})O₃-PbTiO₃ ("PIN-PMN-PT"). Suitable compositions for the crystal include, but are not limited to, 1 mol% Sm: 26PIN-PMN-28PT, 1 mol% Sm: 26PIN-PMN-30PT, and 0.5 mol% Sm: 26PIN-PMN-30PT.

The crystal may include any suitable phase, including, but not limited to, rhombohedral, orthorhombic, tetragonal, and combinations thereof.

In one embodiment, the crystal exhibits less variation of dielectric permittivity and piezoelectric coefficient along a rhombohedral phase section relative to a comparative crystal having a comparative formula of Pb{[(M_{I},M_{II})_{1- z}(M_{I'},M_{II'})_{z}]_{1-y}Ti_{y}}O₃ with the same selections and values for y, z, M_{I}, M_{II}, M_{I'}, and M_{II}, and the same crystal symmetry after poling. In a further embodiment, the crystal exhibits at least 25% less variations of dielectric permittivity and piezoelectric coefficient, alternatively at least 30% less, alternatively at least 35% less, alternatively at least 40% less.

In one embodiment, the crystal exhibits higher piezoelectric coefficient relative to a comparative crystal having a comparative formula of Pb{[(M_{I},M_{II})_{1- z}(M_{I'},M_{II'})_{z}]_{1-y}Ti_{y}}O₃ with the same selections and values for y, z, M_{I}, M_{II}, M_{I'}, and M_{II'} and the same crystal symmetry after poling. In a further embodiment, the crystal exhibits at least 20% higher piezoelectric coefficient, alternatively at least 25% higher, alternatively at least 30% higher, alternatively at least 35% higher.

In one embodiment, the crystal exhibits higher free dielectric permittivity relative to a comparative crystal having a comparative formula of Pb{[(M_{I},M_{II})_{1-z}(M_{I'},M_{II'})_{z}]_{1-y}Ti_{y}}O₃ with the same selections and values for y, z, M_{I}, M_{II}, M_{I'}, and M_{II'} and the same crystal symmetry after poling. In a further embodiment, the crystal exhibits at least 20% higher free dielectric permittivity, alternatively at least 25% higher, alternatively at least 30% higher, alternatively at least 35% higher.

In one embodiment, the crystal exhibits higher clamped dielectric permittivity relative to a comparative crystal having a comparative formula of Pb{[(M_{I},M_{II})_{1-z}(M_{I'},M_{II'})_{z}]_{1-y}Ti_{y}}O₃ with the same selections and values for y, z, M_{I}, M_{II}, M_{I'}, and M_{II'} and the same crystal symmetry after poling. In a further embodiment, the crystal exhibits at least 20% higher clamped dielectric permittivity, alternatively at least 25% higher, alternatively at least 30% higher, alternatively at least 35% higher.

The crystal having the general formula of (Pb_{1-1.5x}Mₓ){[(M_{I},M_{II})_{1-z}(M_{I'},M_{II'})_{z}]_{1-y}Ti_{y}}O₃ may include any suitable value for x, including, but not limited to, 0 < x ≤ 0.05, alternatively 0.001 ≤ x ≤ 0.03, alternatively 0.0015 x ≤ 0.025.

The crystal having the general formula of (Pb_{1-1.5x}Mₓ){[(M_{I},M_{II})_{1-z}(M_{I'},M_{II'})_{z}]_{1-y}Ti_{y}}O₃ may include any suitable value for y, including, but not limited to, 0.02 < y < 0.7, alternatively 0.20 ≤ y ≤ 0.40, alternatively 0.25 ≤ y ≤ 0.35.

The crystal having the general formula of (Pb_{1-1.5x}Mₓ){[(M_{I},M_{II})_{1-z}(M_{I'},M_{II'})_{z}]_{1-y}Ti_{y}}O₃ may include any suitable value for z, including, but not limited to, 0 ≤ z ≤ 1, alternatively 0 ≤ z ≤ 0.40.

A-site modified relaxor-PT based piezoelectric crystals may be grown from their melt using the vertical Bridgman method or any other suitable method. The crystal may be grown along <001>, <110> or <111> orientations, or any suitable arbitrary orientation. The crystals may be poled in any suitable engineered domain configurations. For rhombohedral crystals, it may include [001] poled crystals with 4R engineered domain configuration and [011] poled crystals with 2R engineered domain configuration; for orthorhombic crystals, it may include [001] poled crystals with 40 engineered domain configuration, [111] poled crystals with 30 engineered domain configuration; and for tetragonal crystals, it may include [011] poled crystals with 2T engineered domain configurations [111] poled crystals with 3T engineered domain configuration.

In one embodiment, a vertical Bridgman method is applied to grow the crystals. To keep the crystal growth interface stable in the crystal growth process, at least 98%, alternatively pure, perovskite-phase raw materials may be presynthesized for preventing the pyrochlore phase formation during the raw material batching and spontaneous nucleation/polycrystalline grain growth in crystal growth. As used herein, "pure" indicates at least 99.5%. A precursor method may be adopted to a batching process to prevent the formation of a pyrochlore phase. For preparation, different precursor materials, such as, but not limited to, wolframite, InNbO₄, and columbite, MgNb₂O₆, may be synthesized first, respectively, by calcination of mixed oxides at 1,000-1,300 °C. Following mixing single oxides, such as, but not limited to, PbO/Pb₃O₄, TiO₂, and rare-earth oxides with the precursor materials, feeding material having the general formula of (Pb_{1-1.5x}Mₓ){[(M_{I},M_{II})_{1-z}(M_{I'},M_{II'})_{z}]_{1-y}Ti_{y}} may be synthesized by another calcination process at lower temperature (700-950 °C), and powder x-ray diffraction (XRD) may be used to verify that sufficiently pure perovskite phase is obtained through this precursor method.

The crystals may then be grown from the feeding material having the general formula of (Pb_{1-1.5x}Mₓ){[(M_{I},M_{II})_{1-z}(M_{I'},M_{II'})_{z}]_{1-y}Ti_{y}}O₃ by the Bridgman method without crystal seeds or with crystal seeds of the same kind of crystals. A two heating-zone Bridgman furnace may be used for the crystal growth. The upper zone temperature may be higher than the melting point and lower zone temperature may be below the melting temperature, respectively, of the feeding material. In the Bridgman growth process, the cylindrical Pt crucibles charged with single crystal seeds (if applied) at the bottom and the feeding material in either powder or ceramic form above the seeds may be placed in the two-zone furnace. For growth of small crystals, multiple crucibles may be loaded into the furnace together in a single crystal growth run. By setting temperature of the upper zone 20-150 °C higher than the melting points and the lower zone 50-300 °C lower than the melting point, an axial temperature gradient of <50 °C/cm may be formed between two zones. After the charge and part of the crystal seeds (if applied) are melted in the upper-zone, the crucibles may be lowered down slowly through the temperature gradient resulting in a unidirectional crystallization. By this method, crystals having the general formula of (Pb_{1-1.5x}Mₓ){[(M_{I},M_{II})_{1-z}(M_{I'},M_{II'})_{z}]_{1-y}Ti_{y}}O₃ with different diameter and length may be grown.

### EXAMPLES

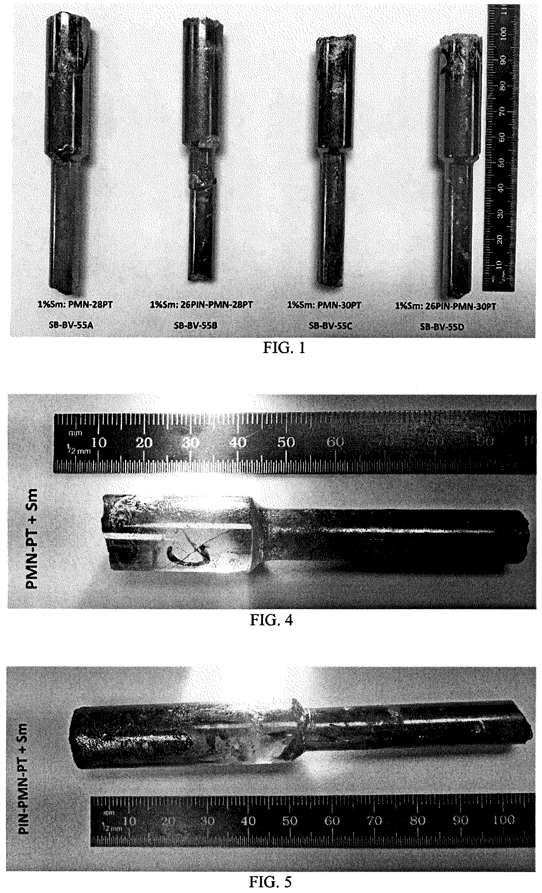

FIG. 1 shows Sm-modified PMN-PT and PIN-PMN-PT single crystals grown by the process described herein. The crystals were oriented using real-time Laue X-ray or an X-ray diffraction unit and then cut to obtain samples with the aspect ratios following IEEE piezoelectric standards (IEEE Standard on Piezoelectricity, ANSI/IEEE Standard, NY, 1987-176). All the samples were oriented along <001>, <110> or <111> directions and gold was sputtered on the surfaces as the electrodes. Crystal samples were poled under 5-16kV/cm at room temperature. High field polarization and strain measurements were performed at room temperature at low frequency using a modified Sawyer-Tower circuit and linear variable differential transducer (LVDT) driven by a lock-in amplifier. Room temperature dielectric, piezoelectric, electromechanical properties were determined according to IEEE standards, by using HP4194A Impedance-phase gain analyzer. The dielectric temperature dependence was measured in the frequency range of 0.1 kHz to 10kHz using a multi-frequency LCR meter (HP4284A), connected to a computer-controlled temperature chamber. The test results of the <001>-poled, Sm-modified PMN-PT and PIN-PMN-PT crystals are summarized in Table 2 in comparison with the unmodified crystals. Some of the A-site modified PMN-PT and PIN-PMN-PT crystals, such as 1 mol% Sm: PMN-28PT, 1 mol% Sm: PMN-30PT, 1 mol% Sm: 26PIN-PMN-28PT, 1 mol% Sm: 26PIN-PMN-30PT and 0.5 mol% Sm: 26PIN-PMN-30PT, have significantly higher free and clamped dielectric permittivity (εᵣ and εᵣ clamped), piezoelectric coefficient (d₃₃) and coupling factor than the ηoη-modified counterparts with compromises on rhombohedral-to-tetragonal phase transition temperature (Tᵣₜ) and dielectric loss (tanδ). In order to take advantage of the impact of A-site substitution, the binary/temary base composition and the substitution level may be optimized. It is seen that 2 mol% of A-site substitution by Sm in PMN-32PT and 26PIN-PMN-32PT shifted the majority of the as-grown crystal boules from rhombohedral phase to tetragonal phase, resulting in lower dielectric permittivity and piezoelectric coefficient. It is also seen that the crystal grown from 26PIN-PMN-28PT with 0.25 mol% Sm substitution on the A-site only possesses moderate dielectric and piezoelectric properties, due to the combination of low substitution level and low PT content. It should be noted that Table 2 only lists the feeding material composition of each crystal; however, each as-grown crystal covers a much broader range of compositions due to the compositional segregation effect, which will be described in further detail below.

**Table 2. The properties of Sm:PMN-PT and Sm:PIN-PMN-PT crystals.**

| Feeding Material | Phase | d₃₃ (pC/N) | tanδ (%) | εᵣ | εᵣ (clamped) | k₃₃ | v (m/s) | Tᵣₜ (°C) | E_{c} (kV/cm) |
|---|---|---|---|---|---|---|---|---|---|
| PMN-30PT | R | 1150-2120 | <0.6 | 4100-5800 | 700-1000 | 0.89-0.93 | 4400-4600 | 88-96 | 2.0-3.0 |
| 26PIN-PMN-30PT | R | 1000-1800 | <0.6 | 3000-5000 | 600-900 | 0.88-0.93 | 4300-4550 | 110-130 | 4.5-6.0 |
| 1 mol% Sm: PMN-28PT | R | 2100-3200 | <1.2 | 6600-11000 | 1150-1700 | 0.89-0.94 | 4300-4550 | 59-75 | 2.0-3.0 |
| 1 mol% Sm: PMN-30PT | R | 2900-3600 | <1.5 | 7600-13000 | 1000-1300 | 0.91-0.94 | 4150-4600 | 47-60 | 2.0-3.0 |
| 2 mol% Sm: PMN-32PT | T | 740-1200 | 2 | 2200-12000 | / | 0.8-0.85 | / | ≤-50 | 2.0-2.6 |
| 1 mol% Sm: 26PIN-PMN-28PT | R | 1700-2600 | <1.2 | 5600-7000 | 1000-1300 | 0.89-0.95 | 4300-4500 | 65-87 | 3.5-6.0 |
| 1 mol% Sm: | R | 2000-2500 | <1.6 | 5900-8200 | 900-1250 | 0.9-0.95 | 4300-4450 | 55-82 | 3.5-6.0 |
| 26PIN-PMN-30PT | | | | | | | | | |
| 2 mol% Sm: 26PIN-PMN-32PT | T | 780-1100 | 2 | 2000-3200 | / | 0.8-0.87 | / | ≤20 | 5.6-6.0 |
| 0.5 mol% Sm: 26PIN-PMN-30PT | R | 1240-2680 | <1.2 | 4600-7800 | 740-940 | 0.89-0.95 | 4200-4400 | 86-94 | 4.7-6.1 |
| 0.25 mol% Sm: 26PIN-PMN-28PT | R | 1000-1500 | <0.7 | 3500-5100 | 580-810 | 0.88-0.94 | 4300-4500 | 98-116 | 5.0-6.0 |

| | | | | | | | | | |
|---|---|---|---|---|---|---|---|---|---|
| *R: Rhombohedral; T: Tetragonal * The samples were poled along <001 > | | | | | | | | | |

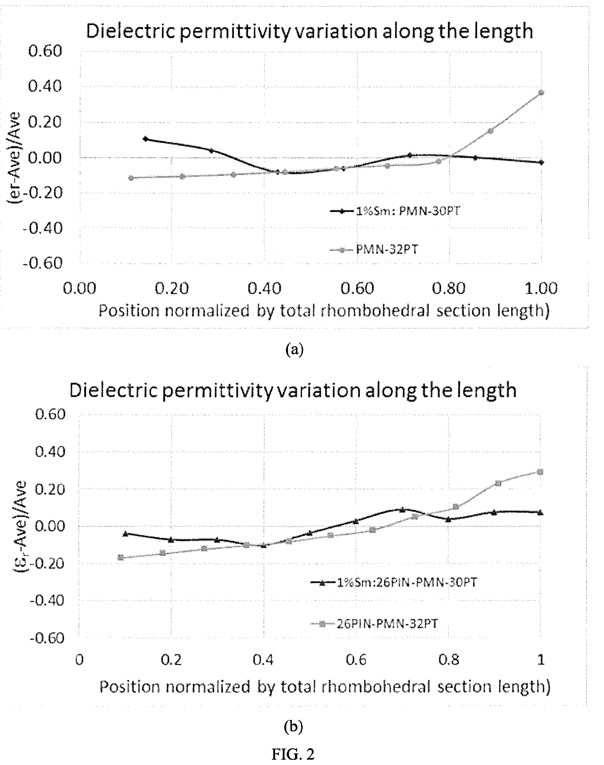

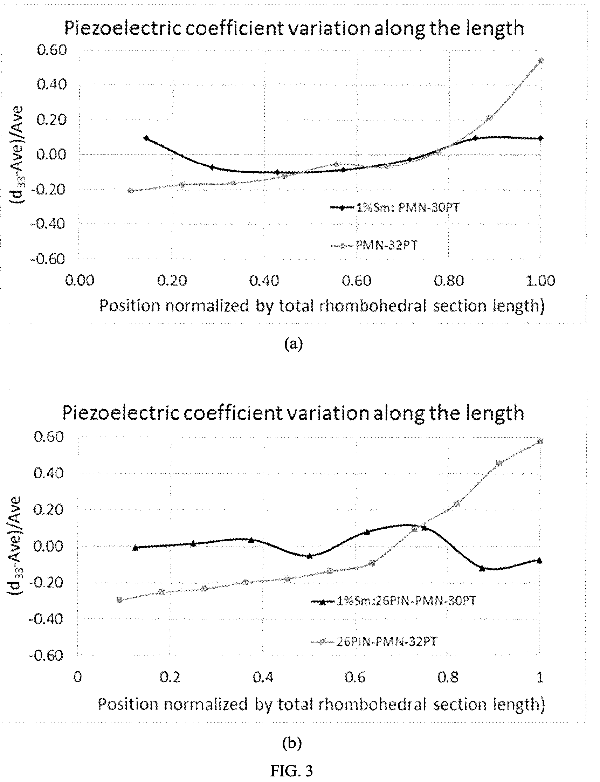

The longitudinal property variations in each crystal were characterized between the unmodified and A-site modified PMN-PT / PIN-PMN-PT crystals by measuring the <001>-poled samples taken from different positions along the length of each crystal. FIGS. 2 and 3 show the variations of dielectric permittivity and piezoelectric coefficient along the length of the unmodified and Sm-modified PMN-PT and PIN-PMN-PT crystals (only the rhombohedral phase section in each of the as-grown crystal). It is clearly seen that Sm may largely suppress the longitudinal property variations in the rhombohedral phase of PMN-PT and PIN-PMN-PT crystals. For example, FIG. 2 in (a) and (b) indicates that the dielectric permittivity totally varied over 45% in the rhombohedral section of a PMN-PT crystal and a PIN-PMN-PT crystal, but only about 19% in Sm-modified crystals of the same types. Similarly, as shown in FIG. 3 in (a) and (b), the piezoelectric coefficient totally varied over 75% in the rhombohedral section of a PMN-PT crystal and a PIN-PMN-PT crystal, but only about 22% in Sm-modified crystals of the same types. It is expected that Sm may reduce the variation of other properties in the crystal. In the same way, some of the other A-site substitutes may have the same impact on the crystals property variations as Sm.

The compositions of some of the as-grown crystals were analyzed by electronic probe microanalysis (EPMA). Due to the compositional segregation in these solid-solution systems, the bottom and top of each crystal boule present different concentrations for most of the main elements. As shown in the Table 3, except for Pb, all other elements in Sm:PMN-PT and Sm:PIN-PMN-PT crystals exhibit compositional segregation during Bridgman growth, exhibiting an effective segregation coefficient either larger than 1 (Nb, Mg, In and Sm) or smaller than 1 (Ti). For In, the composition segregation is quite close to 1 as its concentration is relatively consistent from the bottom to top of the crystal boules.

**Table 3. Crystal composition determined by EPMA (at% normalized to Pb).**

| Crystal ID | Sample location | Mg | Ti | Nb | Sm | In | Zr |
|---|---|---|---|---|---|---|---|
| BV-56B | Bottom | 17.16% | 25.80% | 49.86% | 0.31% | 13.33% | / |
| | Top | 13.58% | 35.17% | 43.41% | 0.17% | 12.67% | / |
| BV-56C | Bottom | 16.80% | 28.50% | 47.66% | 0.62% | 13.15% | / |
| | Top | 14.02% | 33.80% | 45.17% | 0.43% | 12.63% | / |
| BV-55A | Bottom | 24.61% | 29.64% | 51.14% | 0.89% | / | / |
| | Top | 22.76% | 32.90% | 48.66% | 0.36% | / | / |
| BV-54D | Bottom | 15.80% | 29.56% | 46.25% | 2.67% | 13.16% | / |
| | Top | 15.37% | 31.08% | 45.64% | 2.45% | 13.21% | / |
| SB-BIII-16 | Bottom | 18.89% | 22.75% | 39.77% | / | / | 10.92% |
| | Top | 18.89% | 34.58% | 37.06% | / | / | 0.33% |

### Example 1

Sm:PMN-PT crystal growth: A typical Bridgman process for Sm-modified PMN-PT(2 mol% Sm₂O₃ in 68 mol% PMN-32 mol% PT) crystal growth is described as follows. According to the stoichiometry of the PMN-PT compound, PbO, MgNb₂O₆, and TiO₂ were mixed with 2mol% Sm₂O₃. The mixture was milled by zirconia grinding media in a ball mill for 16 hours and then was dried in an oven around 50 °C. The dried powder was sieved through an 80-mesh nylon screen, and then was calcined at 850 °C. Purity of the perovskite phase was confirmed by XRD. The synthesized powder was pressed into small pellets, and then fired at 1250 °C. The ceramic pellets were then charged into a tapered platinum (Pt) crucible. The Pt crucible is 15 mm in diameter and 100 mm long with a 10 mm in diameter and 50 mm long seed well (no single crystal seed was charged into the seed well).

A two heating-zone vertical Bridgman furnace was used for the crystal growth. The maximum temperatures for the upper and lower heating zones were 1390 °C and 1100 °C, respectively. The vertical temperature gradient along the Pt crucible was >5 °C/cm. After the whole charge was melted, it was soaked for 10 hours, and then the crucible was lowered down at a rate of 0.6 mm/hour to initiate the crystallization process at the bottom of the Pt crucible. After moving the crucible down about 150 mm, the crystallization process driven by the vertical temperature gradient was completed. Then the furnace was cooled down to room temperature in 78 hours. Yielded was a single crystal (except for the very beginning part of the boule) with a diameter of 10-15 mm and about 90 mm long and was grown roughly along the <11 I>-orientation. FIG. 4 is a photograph of this crystal boule.

### Example 2

Sm:PIN-PMN-PT crystal growth: A typical Bridgman process for Sm-modified PIN-PMN-PT (2 mol% Sm₂O₃ in 26 mol% PIN-42 mol% PMN-32 mol% PT) crystal growth is described as follows. According to the stoichiometry of the PIN-PMN-PT compound, PbO, MgNb₂O₆, InNbO₄ and TiO₂ were mixed with 2 mol% Sm₂O₃. The mixture was milled by zirconia grinding media in a ball mill for 16 hours and then was dried in an oven around 50 °C. The dried powder was sieved through an 80-mesh nylon screen, and then was calcined at 850 °C. Purity of the perovskite phase was confirmed by XRD. The synthesized powder was pressed into small pellets, and then fired at 1250 °C. The ceramic pellets were then charged into a tapered platinum (Pt) crucible. The Pt crucible is 15mm in diameter and 100 mm long with a 10 mm in diameter and 50 mm long seed well (no single crystal seed was charged into the seed well).

A two heating-zone vertical Bridgman furnace was used for the crystal growth. The maximum temperatures for the upper and lower heating zones were 1390 °C and 1100 °C, respectively. The vertical temperature gradient along the Pt crucible was >5 °C/cm. After the whole charge was melted, it was soaked for 10 hours, and then the crucible was lowered down at a rate of 0.6 mm/hour to initiate the crystallization process at the bottom of the Pt crucible. After moving the crucible down about 150 mm, the crystallization process driven by the vertical temperature gradient was completed. Then the furnace was cooled down to room temperature in 78 hours. Yielded was a single crystal (except for the very beginning part of the boule) with a diameter of 10-15 mm and about 110 mm long and was grown roughly along the disorientation. FIG. 5 is a photograph of this crystal boule.

### Example 3

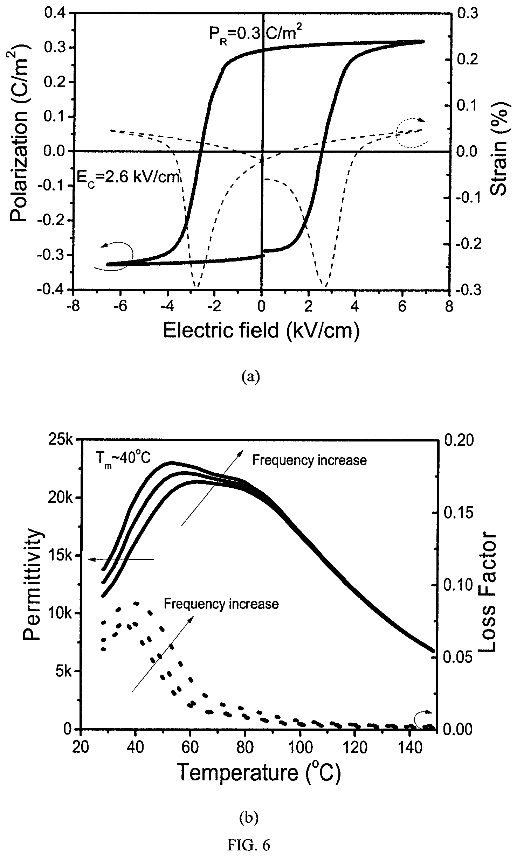

Sm: PMN-PT crystal testing: Piezoelectric and dielectric properties of Sm-modified PMN-PT (2 mol% Sm₂O₃ in 68 mol% PMN-32 mol% PT) crystal grown in Experiment 1 have been measured. First, the single crystal boules were oriented by a real-time Laue X-ray photography system. Then thin plate samples with a width to thickness ratio of about 10:1 were cut from the boules with the pair of large faces of the plates in {001} family. After Au electrodes were sputtered onto the pair of large faces, the hysteresis cycles of the polarization and the strain were measured by using the Sawyer-Tower polarization and LVDT strain measurement system under a 10 kV/cm, 0.1-10 Hz AC field, from which the remnant polarization (Pᵣ), coercive field (E_{c}) and piezoelectric coefficient (d₃₃) of the samples were obtained; meanwhile, the samples were poled along <001> (through the thickness). Dielectric permittivity and loss vs. temperature were measured within the temperature range 25-150 °C by a HP4174A LCR meter connected to a temperature chamber. The Curie temperature (T_{C}) & rhombohedral-to-tetragonal phase transition temperature (Tᵣₜ) were then determined by the maximum peaks of the dielectric permittivity. The measured dielectric and piezoelectric properties are shown in FIG. 6.

### Example 4

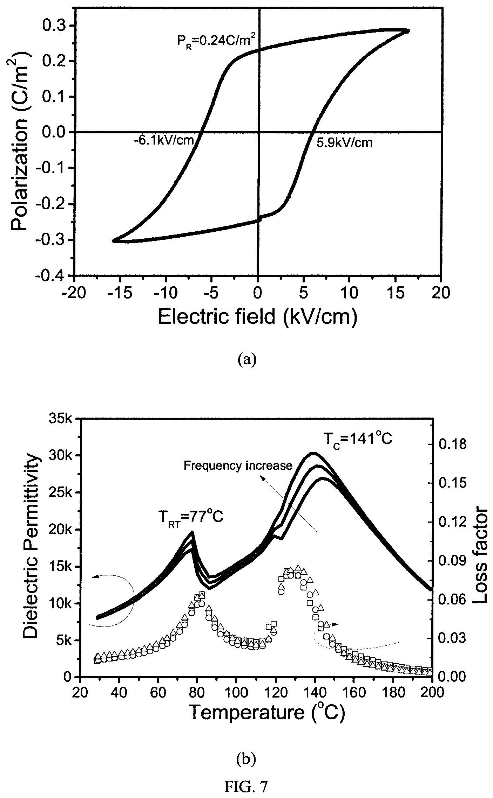

Sm:PIN-PMN-PT crystal testing: Piezoelectric and dielectric properties of Sm-modified crystal grown from 26 mol% PIN-PMN-30 mol% PT (with 1 mol% Sm₂O₃ substitution) have been measured. First, the single crystal boules were oriented by a real-time Laue X-ray photography system. Then thin plate samples with a width to thickness ratio of about 10:1 were cut from the boules with the pair of large faces of the plates in {001} family. After Cr/Au electrodes were sputtered on the pair of large face, the hysteresis cycles of the polarization were measured by using the Sawyer-Tower polarization and LVDT strain measurement system under a 10 kV/cm, 0.1-10 Hz AC field, from which coercive field (E_{c}) and piezoelectric coefficient (d₃₃) of the samples were obtained; meanwhile, the samples were poled along <001> (through the thickness). Dielectric permittivity and loss vs. temperature were measured within the temperature range 25-200 °C by a HP4174A LCR meter connected to a temperature chamber. The Curie temperature (T_{c}) & rhombohedral-to-tetragonal phase transition temperature (Tᵣₜ) were then determined by the maximum peaks of the dielectric permittivity. The measured dielectric and piezoelectric properties are shown in Table 4. and FIG. 7.

**Table 4. The properties of the <001>-poled samples from a Sm:PIN-PMN-PT crystal.**

| Samples | εᵣ | tanδ (%) | εᵣ (clamped) | d₃₃ (pC/N) | Tᵣₜ(T_{C}) (°C) | E_{C} (kV/cm) |
|---|---|---|---|---|---|---|
| D5-3 | 7640 | 0.7 | 1050 | 2150 | 77 (141) | 6.0 |
| D7-3 | 7230 | 1.2 | 900 | 2000 | 82 (143) | 5.6 |

### Example 5

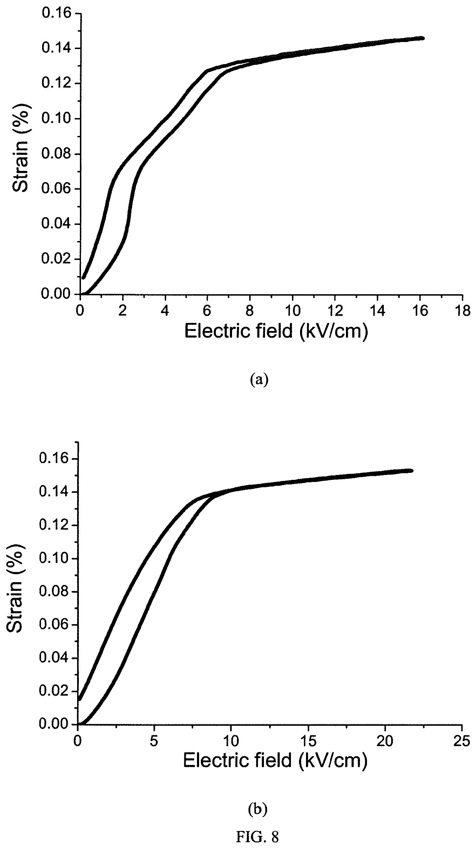

<111>-poled Sm-modified crystal testing: Piezoelectric and dielectric properties of Sm-modified crystal grown from PMN-32 mol% PT and 26 mol% PIN-PMN-32 mol% PT (both with 2 mol% Sm₂O₃ substitution) have been measured. First, the single crystal boules were oriented by a real-time Laue X-ray photography system. Then thin plate samples with a width to thickness ratio of about 10:1 were cut from the boules with the pair of large faces of the plates in {111} family. After Cr/Au electrodes were sputtered on the pair of large faces, the polarization and strain were measured by using the Sawyer-Tower polarization and LVDT strain measurement system under a 10 kV/cm, 0.1-10 Hz AC and DC fields, from which coercive field (E_{c}) and piezoelectric coefficient (d₃₃) of the samples were obtained; meanwhile, the samples were poled along <111> (through the thickness). Dielectric permittivity and loss vs. temperature were measured within the temperature range 25-200 °C by a HP4174A LCR meter connected to a temperature chamber. The Curie temperature (T_{c}) & rhombohedral-to-tetragonal phase transition temperature (Tᵣₜ) were then determined by the maximum peaks of the dielectric permittivity. The dielectric and piezoelectric properties measured at room temperature (except for Tᵣₜ /T_{C}) are shown in Table 5. and FIG. 8. At room temperature, Samples 1 and 2 may be in orthorhombic and tetragonal phases, respectively.

**Table 5. The properties of the <111>-poled longitudinal mode samples from Sm-modified crystals .**

| Sample | Sample from | εᵣ | tanδ (%) | εᵣ (clamped) | d₃₃ (pC/N) | Tᵣₜ(T_{C}) (°C) | E_{C} (kV/cm) |
|---|---|---|---|---|---|---|---|
| 1 | 2 mol%: Sm:PMN-32PT | 17000 | <2 | 5000 | 1400 | -30 (80) | 4.0 |
| 2 | 2 mol%: Sm:26PIN-PMN-32PT | 10500 | <2 | 3600 | 900 | -20 (135) | 7.7 |

## Claims

1. A relaxor-PT based piezoelectric crystal comprising the general formula of (Pb_{1-1.5x}Mₓ){[(M_{I},M_{II})_{1-z}(M_{I'},M_{II'})_{z}]_{1-y}Ti_{y}}O₃, wherein:
M is a rare earth cation;
M_{I} is selected from the group consisting of Mg²⁺, Zn²⁺, Yb³⁺, Sc³⁺, and In³⁺;
M_{II} is Nb⁵⁺;
M_{I'} is selected from the group consisting of Mg²⁺, Zn²⁺, Yb³⁺, Sc³⁺, In³⁺ and Zr⁴⁺;
M_{II'} is Nb⁵⁺ or Zr⁴⁺; $0 < x \leq 0.05 ;$ $0.02 < y < 0.7 ;$ and $0 \leq z \leq 1 ,$
provided that if either M_{I'} or M_{II'} is Zr⁴⁺, both M_{I'} and M_{II}, are Zr⁴⁺,
provided that M is selected from the group consisting of Nd³⁺, Pm³⁺, Sm³⁺, Gd³⁺ and combinations thereof, and
wherein the relaxor-PT based piezoelectric crystal is a single crystal.

2. The crystal of claim 1, wherein z is 0, and the crystal is a binary crystal.

3. The crystal of claim 2, wherein M_{I} is selected from the group consisting of Mg²⁺, Zn²⁺, Yb³⁺, Sc³⁺, and In³⁺, and M_{II} is Nb⁵⁺.

4. The crystal of claim 1, wherein z is greater than 0, and the crystal is a ternary crystal.

5. The crystal of claim 4, wherein M_{I} is selected from the group consisting of Mg²⁺, Zn²⁺, Yb³⁺, Sc³⁺, and In³⁺, M_{II} is Nb⁵⁺, and M_{I'} and M_{II'} are each Zr⁴⁺.

6. The crystal of claim 4, wherein M_{I} and M_{II} are each independently selected from the group consisting of Mg²⁺, Zn²⁺, Yb³⁺, Sc³⁺, and In³⁺, and M_{I'} and M_{II'} are each Nb⁵⁺.

7. The crystal of claim 1, wherein M is Sm³⁺.

8. The crystal of claim 1, wherein the crystal is an M-modified Pb(Mg_{1/3}Nb_{2/3})O₃-PbTiO₃ "PMNT".

9. The crystal of claim 1, wherein the crystal is an M-modified Pb(In_{1/2}Nb_{1/2})O₃-Pb(Mg_{1/3}Nb_{2/3})O₃-PbTiO₃ "PIN-PMN-PT".

10. The crystal of claim 9, comprising one of the following features:
- the crystal is 1 mol% Sm: 26PIN-PMN-28PT; or
- the crystal is 1 mol% Sm: 26PIN-PMN-30PT; or
- the crystal is 0.5 mol% Sm: 26PIN-PMN-30PT.

11. The crystal of claim 1, comprising one of the following features:
- the crystal includes a phase selected from the group consisting of rhombohedral, orthorhombic, tetragonal, and combinations thereof; or
- the crystal exhibits at least 25% less variations of dielectric permittivity and piezoelectric coefficient along a rhombohedral phase section relative to a comparative crystal having a comparative formula of Pb{[(M_{I},M_{II})_{1-z}(M_{I'},M_{II'})_{z}]_{1-y}Ti_{y}}O₃ with the same selections and values for y, z, M_{I}, M_{II}, M_{I'}, and M_{II'} and the same crystal symmetry after poling; or
- the crystal exhibits at least 20% higher piezoelectric coefficient relative to a comparative crystal having a comparative formula Pb{[(M_{I},M_{II})_{1-z}(M_{I'},M_{II'})_{z}]_{1-y}Ti_{y}}O₃ with the same selections and values for y, z, M_{I}, M_{II}, M_{I'}, and M_{II'} and the same crystal symmetry after poling; or
- the crystal exhibits at least 20% higher free dielectric permittivity relative to a comparative crystal having a comparative formula of Pb{[(M_{I},M_{II})_{1-z}(M_{I'},M_{II'})_{z}]_{1-y}Ti_{y}}O₃ with the same selections and values for y, z, M_{I}, M_{II}, M_{I'}, and M_{II'} and the same crystal symmetry after poling; or
- the crystal exhibits at least 20% higher clamped dielectric permittivity relative to a comparative crystal having a comparative formula of Pb{[(M_{I},M_{II})_{1-z}(M_{I'},M_{II'})_{z}]_{1-y}Ti_{y}}O₃ with the same selections and values for y, z, M_{I}, M_{II}, M_{I'}, and M_{II'} and the same crystal symmetry after poling; or
- $0.0015 \leq x \leq 0.025 ;$ or
- $0.25 < y < 0.35 ;$ or
- $0 \leq z \leq 0.40 ,$ and
wherein the piezoelectric and dielectric properties are measured according to the description.

12. A method for forming a relaxor-PT based piezoelectric crystal, comprising:
pre-synthesizing precursor materials by calcining mixed oxides at a first calcination temperature;
mixing the precursor materials with single oxides and calcining at a second calcination temperature lower than the first calcination temperature to form a feeding material having the general formula of (Pb_{1-1.5x}Mₓ){[(M_{I},M_{II})_{1-z}(M_{I'},M_{II'})_{z}]_{1-y}Ti_{y}}O₃; and
growing the relaxor-PT based piezoelectric crystal according to claim 1 having the general formula of (Pb_{1-1.5x}Mₓ){[(M_{I},M_{II})_{1-z}(M_{I'},M_{II'})_{z}]_{1-y}Ti_{y}}O₃ from the feeding material by a Bridgman method.

13. The method of claim 12, wherein method comprises one of the following features:
- the feeding material is at least 98% perovskite-phase; or
- the feeding material is pure perovskite-phase; or
- the precursor materials are selected from the group consisting of InNbO₄ and MgNb₂O₆; or
- the single oxides are selected from the group consisting of PbO/Pb₃O₄, TiO₂, and rare-earth oxides; or
- the first calcination temperature is within the range of 1,000- 1,300 °C; or
- the second calcination temperature is within the range of 700-950 °C; or
- the Bridgman method includes a two heating zone Bridgman furnace having an upper heating zone 20-150 °C higher than a melting point of the feeding material and a lower heating zone 50-300 °C lower than the melting point of the feeding material; or
- the second calcination temperature is within the range of 700-950 °C, and wherein the Bridgman furnace includes an axial temperature gradient of <50 °C/cm between the upper heating zone and the lower heating zone.

14. Use of a relaxor-PT based piezoelectric crystal according to any of claims 1 to 11 in a medical ultrasonic transducer.

## Patentansprüche

1. Piezoelektrischer Kristall auf Relaxor-PT-Basis mit der allgemeinen Formel (Pb_{1-1.5x}Mₓ){[(M_{I,}M_{II'1-Z}(M_{I',}M_{II')Z}]1-yTi_{y}}O₃ wobei:
M ein Seltenerdkation ist,
M_{I} aus der aus Mg²⁺, Zn²⁺, Yb³⁺, Sc³⁺ und In³⁺ bestehenden Gruppe ausgewählt ist,
M_{II} Nb⁵⁺ ist,
M_{I'} aus der aus Mg²⁺, Zn²⁺, Yb³⁺, Sc³⁺, In³⁺ und Zr⁴⁺ bestehenden Gruppe ausgewählt ist,
M_{II'} Nb⁵⁺ oder Zr⁴⁺ ist, $0 < x \leq 0 , 05 ,$ $0 , 02 < y < 0 , 7$ und $0 \leq z \leq 1 ,$
mit der Maßgabe, dass, wenn entweder M_{I'} oder M_{II'} Zr⁴⁺ ist, sowohl M_{I'} als auch M_{II'} Zr⁴⁺ sind,
mit der Maßgabe, dass M aus der aus Nd³⁺, Pm³⁺, Sm³⁺, Gd³⁺ und Kombinationen daraus bestehenden Gruppe ausgewählt ist, und
wobei der piezoelektrische Kristall auf Relaxor-PT-Basis ein Einkristall ist.

2. Kristall nach Anspruch 1, bei dem z gleich 0 ist und der Kristall ein binärer Kristall ist.

3. Kristall nach Anspruch 2, bei dem M_{I} aus der aus Mg²⁺, Zn²⁺, Yb³⁺, Sc³⁺ und In³⁺ bestehenden Gruppe ausgewählt ist und M_{II} Nb⁵⁺ ist.

4. Kristall nach Anspruch 1, bei dem z größer als 0 ist und der Kristall ein ternärer Kristall ist.

5. Kristall nach Anspruch 4, bei dem M_{I} aus der aus Mg²⁺, Zn²⁺, Yb³⁺, Sc³⁺ und In³⁺ bestehenden Gruppe ausgewählt ist, M_{II} Nb⁵⁺ ist und M_{I'} und M_{II'} jeweils Zr⁴⁺ sind.

6. Kristall nach Anspruch 4, bei dem M_{I} und M_{II} jeweils unabhängig voneinander aus der aus Mg²⁺, Zn²⁺, Yb³⁺, Sc³⁺ und In³⁺ bestehenden Gruppe ausgewählt sind und M_{I'} und M_{II'} jeweils Nb⁵⁺ sind.

7. Kristall nach Anspruch 1, bei dem M Sm³⁺ ist.

8. Kristall nach Anspruch 1, wobei der Kristall ein M-modifiziertes Pb(Mg_{1/3}Nb_{2/3})O₃-PbTiO₃ "PMNT" ist.

9. Kristall nach Anspruch 1, wobei der Kristall ein M-modifiziertes Pb(In_{1/2}Nb_{1/2})O₃-Pb(Mg_{1/3}Nb_{2/3})O₃-PbTiO₃ "PIN-PMN-PT" ist.

10. Kristall nach Anspruch 9, der eines der folgenden Merkmale aufweist:
- der Kristall besteht zu 1 Mol-% aus Sm: 26PIN-PMN-28PT oder
- der Kristall besteht zu 1 Mol-% aus Sm: 26PIN-PMN-30PT oder
- der Kristall besteht zu 0,5 Mol-% aus Sm: 26PIN-PMN-30PT.

11. Kristall nach Anspruch 1, der eines der folgenden Merkmale aufweist:
- der Kristall weist eine Phase auf, die aus der Gruppe ausgewählt ist, die aus rhomboedrisch, orthorhombisch, tetragonal und Kombinationen daraus besteht, oder
- der Kristall zeigt mindestens 25 % weniger Schwankungen der dielektrischen Leitfähigkeit und des piezoelektrischen Koeffizienten entlang eines rhomboedrischen Phasenabschnitts gegenüber einem Vergleichskristall einer Vergleichsformel Pb{[(M_{I},M_{II})_{1-z}(M_{I'},M_{II'})_{z}]_{1-y}Ti_{y}}O₃ bei gleichen Auswahlen und Werten für y, z, M_{I}, M_{II}, M_{I'} und M_{II'} und der gleichen Kristallsymmetrie nach der Polung, oder
- der Kristall zeigt einen um mindestens 20 % höheren piezoelektrischen Koeffizienten gegenüber einem Vergleichskristall einer Vergleichsformel Pb{[(M_{I},M_{II})_{1-z}(M_{I'},M_{II'})_{z}]_{1-y}Ti_{y}}O₃ bei gleichen Auswahlen und Werten für y, z, M_{I}, M_{II}, M_{I'} und M_{II'} und der gleichen Kristallsymmetrie nach der Polung, oder
- der Kristall zeigt eine um mindestens 20 % höhere freie dielektrische Leitfähigkeit gegenüber einem Vergleichskristall einer Vergleichsformel Pb{[(M_{I},M_{II})_{1-z}(M_{I'},M_{II'})_{z}]_{1-y}Ti_{y}}O₃ bei gleichen Auswahlen und Werten für y, z, M_{I}, M_{II}, M_{I'} und M_{II'} und der gleichen Kristallsymmetrie nach der Polung, oder
- der Kristall zeigt eine um mindestens 20 % höhere geklemmte dielektrische Leitfähigkeit gegenüber einem Vergleichskristall einer Vergleichsformel Pb{[(M_{I},M_{II})_{1-z}(M_{I'},M_{II'})_{z}]_{1-y}Ti_{y}}O₃ bei gleichen Auswahlen und Werten für y, z, M_{I}, M_{II}, M_{I'} und M_{II'} und der gleichen Kristallsymmetrie nach der Polung, oder
- $0 , 0015 \leq x \leq 0 , 025$ oder
- $0 , 25 < y < 0 , 35$ oder
- $0 \leq z \leq 0 , 40$ und
wobei die piezoelektrischen und dielektrischen Eigenschaften gemäß der Beschreibung gemessen werden.

12. Verfahren zur Bildung eines piezoelektrischen Kristalls auf Relaxor-PT-Basis, das Folgendes umfasst:
Vorsynthetisieren von Vorläufermaterialien durch Kalzinieren von Mischoxiden bei einer ersten Kalzinierungstemperatur,
Mischen der Vorläufermaterialien mit Einzeloxiden und Kalzinieren bei einer zweiten Kalzinierungstemperatur, die niedriger als die erste Kalzinierungstemperatur ist, zur Bildung eines Zuführmaterials der allgemeinen Formel (Pb_{1-1,5x}Mₓ){[(M_{I},M_{II})_{1-z}(M_{I'},M_{II'})_{z}]_{1-y}Ti_{y}}O₃, und
Züchten des piezoelektrischen Kristalls auf Relaxor-PT-Basis nach Anspruch 1 mit der allgemeinen Formel (Pb_{1-1,5x}Mₓ){[(M_{I},M_{II})_{1-z}(M_{I'},M_{II'})_{z}]_{1-y}Ti_{y}}O₃ aus dem Zuführmaterial mittels eines Bridgman-Verfahrens.

13. Verfahren nach Anspruch 12, wobei das Verfahren eines der folgenden Merkmale umfasst:
- bei dem Zuführmaterial handelt es sich zu mindestens 98 % um die Perowskit-Phase, oder
- bei dem Zuführmaterial handelt es sich um reine Perowskit-Phase, oder
- die Vorläufermaterialien werden aus der aus InNbO₄ und MgNb₂O₆ bestehenden Gruppe ausgewählt, oder
- die Einzeloxide werden aus der aus PbO/Pb₃O₄, TiO₂ und Seltenerdoxiden bestehenden Gruppe ausgewählt, oder
- die erste Kalzinierungstemperatur liegt im Bereich von 1.000-1.300 °C, oder
- die zweite Kalzinierungstemperatur liegt im Bereich von 700-950 °C, oder
- das Bridgman-Verfahren umfasst einen Bridgman-Ofen, der zwei Heizzonen aufweist, mit einer oberen Heizzone, die 20-150 °C über einem Schmelzpunkt des Zuführmaterials liegt, und einer unteren Heizzone, die 50-300 °C unter dem Schmelzpunkt des Zuführmaterials liegt, oder
- die zweite Kalzinierungstemperatur liegt im Bereich von 700-950 °C, und wobei der Bridgman-Ofen einen axialen Temperaturgradienten von <50 °C/cm zwischen der oberen Heizzone und der unteren Heizzone aufweist.

14. Verwendung eines piezoelektrischen Kristalls auf Relaxor-PT-Basis nach einem der Ansprüche 1 bis 11 in einem medizinischen Ultraschallwandler.

## Revendications

1. Cristal piézoélectrique à base de relaxeur-PT présentant la formule générale (Pb_{1-1.5x}Mₓ){[(M_{I,}M_{II'1-Z}(M_{I',}M_{II')Z}]1-yTi_{y}}O₃ dans lequel:
M est un cation de terre rare ;
M_{I} est choisi dans le groupe constitué de Mg²⁺, Zn²⁺, Yb³⁺, Sc³⁺ et In³⁺ ;
M_{II} est du Nb⁵⁺ ;
M_{I'} est choisi dans le groupe constitué de Mg²⁺, Zn²⁺, Yb³⁺, Sc³⁺, In³⁺ et Zr⁴⁺ ;
M_{II'} est du Nb⁵⁺ or du Zr⁴⁺ ; $0 < x \leq 0 , 05 ;$ $0 , 02 < y < 0 , 7 ;$ et $0 \leq z \leq 1 ,$
à condition que, si M_{I'} ou M_{II'} est du Zr⁴⁺, M_{I'} et M_{II'} sont tous deux du Zr⁴⁺,
à condition que M est choisi dans le groupe constitué de Nd³⁺, Pm³⁺, Sm³⁺, Gd³⁺ et de leurs combinaisons, et
dans lequel le cristal piézoélectrique à base de relaxeur-PT est un monocristal.

2. Cristal selon la revendication 1, dans lequel z est égal à 0 et le cristal est un cristal binaire.

3. Cristal selon la revendication 2, dans lequel M_{I} est choisi dans le groupe constitué de Mg²⁺, Zn²⁺, Yb³⁺, Sc³⁺ et In³⁺, et M_{II} est du Nb⁵⁺.

4. Cristal selon la revendication 1, dans lequel z est supérieur à 0 et le cristal est un cristal ternaire.

5. Cristal selon la revendication 4, dans lequel M_{I} est choisi dans le groupe constitué de Mg²⁺, Zn²⁺, Yb³⁺, Sc³⁺ et In³⁺, M_{II} est du Nb⁵⁺, et M_{I'} et M_{II'} sont chacun du Zr⁴⁺.

6. Cristal selon la revendication 4, dans lequel M_{I} et M_{II} sont chacun choisis indépendamment dans le groupe constitué de Mg²⁺, Zn²⁺, Yb³⁺, Sc³⁺ et In³⁺, et M_{I'} et M_{II'} sont chacun du Nb⁵⁺.

7. Cristal selon la revendication 1, dans lequel M est du Sm³⁺.

8. Cristal selon la revendication 1, dans lequel le cristal est un « PMNT » Pb(Mg_{1/3}Nb_{2/3})O₃-PbTiO₃ modifié par M.

9. Cristal selon la revendication 1, dans lequel le cristal est un « PIN-PMN-PT » Pb(In_{1/2}Nb_{1/2})O₃-Pb(Mg_{1/3}Nb_{2/3})O₃-PbTiO₃ modifié par M.

10. Cristal selon la revendication 9, présentant l'une des caractéristiques suivantes :
- le cristal est constitué à 1 % en moles de Sm : 26PIN-PMN-28PT ; ou
- le cristal est constitué à 1 % en moles de Sm : 26PIN-PMN-30PT ; ou
- le cristal est constitué à 0,5 % en moles de Sm : 26PIN-PMN-30PT.

11. Cristal selon la revendication 1, présentant l'une des caractéristiques suivantes :
- le cristal comprend une phase choisie dans le groupe constitué des phases rhomboédrique, orthorhombique, tétragonale et de leurs combinaisons ; ou
- le cristal présente au moins 25 % de variations en moins de la permittivité diélectrique et du coefficient piézoélectrique le long d'une section de phase rhomboédrique par rapport à un cristal de comparaison ayant une formule de comparaison Pb{[(M_{I},M_{II})_{1-z}(M_{I'},M_{II'})_{z}]_{1-y}Ti_{y}}O₃ avec les mêmes choix et valeurs pour y, z, M_{I}, M_{II}, M_{I'}, et M_{II'} ainsi que la même symétrie cristalline après polarisation ; ou
- le cristal présente un coefficient piézoélectrique supérieur d'au moins 20 % par rapport à un cristal de comparaison ayant une formule de comparaison Pb{[(M_{I},M_{II})_{1-z}(M_{I'},M_{II'})_{z}]_{1-y}Ti_{y}}O₃ avec les mêmes choix et les mêmes valeurs pour y, z, M_{I}, M_{II}, M_{I'}, et M_{II'} ainsi que la même symétrie cristalline après polarisation ; ou
- le cristal présente une permittivité diélectrique libre supérieure d'au moins 20 % par rapport à un cristal de comparaison ayant une formule de comparaison Pb{[(M_{I},M_{II})_{1-z}(M_{I'},M_{II'})_{z}]_{1-y}Ti_{y}}O₃ avec les mêmes choix et les mêmes valeurs pour y, z, M_{I}, M_{II}, M_{I'}, et M_{II'} ainsi que la même symétrie cristalline après polarisation ; ou
- le cristal présente une permittivité diélectrique bloquée supérieure d'au moins 20 % par rapport à un cristal de comparaison ayant une formule de comparaison Pb{[(M_{I},M_{II})_{1-z}(M_{I'},M_{II'})_{z}]_{1-y}Ti_{y}}O₃ avec les mêmes choix et les mêmes valeurs pour y, z, M_{I}, M_{II}, M_{I'}, et M_{II'} ainsi que la même symétrie cristalline après polarisation ; ou
- $0 , 0015 \leq x \leq 0 , 025 ;$ ou
- $0 , 25 < y < 0 , 35 ;$ ou
- $0 \leq z \leq 0 , 40 ,$ et
les propriétés piézoélectriques et diélectriques étant mesurées conformément à la description.

12. Procédé de formation d'un cristal piézoélectrique à base de relaxeur-PT, comprenant :
la présynthèse de matériaux précurseurs par calcination d'oxydes mélangés à une première température de calcination ;
le mélange des matériaux précurseurs avec des oxydes simples et calcination à une deuxième température de calcination inférieure à la première température de calcination afin de former un matériau d'alimentation présentant la formule générale (PD_{1-1.5x}Mₓ){[(M_{I},M_{II})_{1-z}(M_{I'},M_{II'})_{z}]_{1-y}Ti_{y}}O₃ ; et
la croissance du cristal piézoélectrique à base de relaxeur-PT selon la revendication 1 présentant la formule générale (Pb_{1-1.5x}Mₓ){[(M_{I},M_{II})_{1-z}(M_{I'},M_{II'})_{z}]_{1-y}Ti_{y}}O₃ à partir du matériau d'alimentation par un procédé de Bridgman.

13. Procédé selon la revendication 12, le procédé présentant l'une des caractéristiques suivantes :
- le matériau d'alimentation se compose d'au moins 98 % de phase pérovskite ; ou
- le matériau d'alimentation est une phase pérovskite pure ; ou
- les matériaux précurseurs sont choisis dans le groupe constitué de InNbO₄ et MgNb₂O₆ ; ou
- les oxydes simples sont choisis dans le groupe constitué de PbO/Pb₃O₄, TiO₂ et d'oxydes de terres rares ; ou
- la première température de calcination est comprise dans la plage de 1000 à 1300 °C ; ou
- la deuxième température de calcination est comprise dans la plage de 700 à 950 °C ; ou
- le procédé de Bridgman comprend un four de Bridgman à deux zones de chauffage comportant une zone de chauffage supérieure dont la température est supérieure de 20 à 150 °C à un point de fusion du matériau d'alimentation et une zone de chauffage inférieure dont la température est inférieure de 50 à 300 °C au point de fusion du matériau d'alimentation ; ou
- la deuxième température de calcination est comprise dans la plage de 700 à 950 °C, et le four de Bridgman présente un gradient de température axial de < 50 °C/cm entre la zone de chauffage supérieure et la zone de chauffage inférieure.

14. Utilisation d'un cristal piézoélectrique à base de relaxeur-PT selon l'une des revendications 1 à 11 dans un transducteur ultrasonique médical.
